# EUROPEAN PATENT APPLICATION

(11) **EP 2 897 177 A1**
(43) Date of publication of application: **22.07.2015**
(21) Application number: 13819998.9
(22) Date of filing: 18.06.2013
(51) Int. Cl.: H01L 31/042, C23C 28/00

(54) **WIRING MATERIAL, SOLAR CELL MODULE, AND METHOD FOR MANUFACTURING SOLAR CELL MODULE**

(30) Priority: 17.07.2012 JP 2012158781
(71) Applicant: Dexerials Corporation, Tokyo 141-0032 (JP)
(72) Inventor: NISHIMOTO Masahiro, Tokyo 141-0032 (JP); MORI Daichi, Tokyo 141-0032 (JP)
(74) Representative: Müller Hoffmann & Partner
(86) International application number: PCT/JP2013/066740
(87) International publication number: WO 2014/013828

(57) **Abstract**

A wiring member (15, 16) includes: a conductor (20) having a first face (20a) and a second face (20b) that is located opposite to the first face; a first layer (21) provided on the first face of the conductor, and containing a flux component and an anti-corrosive component; and a second layer (23) provided on the second face of the conductor, and including an adhesive (22).

## Description

### TECHNICAL FIELD

The invention relates to a wiring member suitable for connecting an electrode formed on a surface of a solar cell to a terminal box that collects electric power generated by the solar cell, to a solar cell module in which the wiring member is used, and to a method of manufacturing a solar cell module.

### BACKGROUND ART

In recent years, a reduction in an environmental burden has been a global issue. Under such circumstances, high expectations have been placed on solar power generation that provides a clean, renewable energy. Up to now, a mainstream photovoltaic device is a bulk silicon photovoltaic device in which a crystal of a monocrystalline silicon or a polycrystalline silicon is manufactured and the crystal is sliced to use the thus-obtained crystal as a plate-shaped semiconductor. The bulk silicon photovoltaic device, however, requires much energy and time for growing a silicon crystal, as well as complicated process steps in a manufacturing process thereof.

On the other hand, a thin-film photovoltaic device, in which a semiconductor layer serving as a photoelectric conversion layer is formed on a substrate made of a glass, a stainless steel, or the like is considered to be the mainstream photovoltaic device in the future by virtue of its features of being thin in size, light in weight, low in manufacturing costs, easy to increase area, and so forth. Examples of such a thin-film photovoltaic device include: a thin-film silicon photovoltaic device of a type in which an amorphous silicon film or a microcrystalline silicon film is used; a thin-film silicon photovoltaic device of a type in which those films are used in tandem; and a CIGS-based photovoltaic device in which a compound semiconductor having a combination of elements typified by Cu (copper), In (indium), Ga (gallium), and Se (selenium) is used.

In those thin-film photovoltaic devices, a formation system such as a plasma CVD system and a sputtering system is used to stack a semiconductor layer or a metal electrode film on an inexpensive substrate having large area, following which a photoelectric conversion layer fabricated on the same substrate is subjected to laser patterning or the like for separation of the photoelectric conversion layer to form a plurality of solar cells. Thereafter, the thus-formed solar cells are connected to one another to form a solar cell string.

For example, a thin-film photovoltaic device may include a plurality of solar cells in each of which a transparent electrode film made of a transparent conductive film, a photoelectric conversion layer, and a backside electrode film are stacked on a translucent insulating substrate. Each of the solar cells has an elongated strip shape, and has a length extending substantially across the overall width of the translucent insulating substrate. Also, the thin-film photovoltaic device may have a configuration in which the transparent electrode film of one of the mutually-adjacent solar cells is connected to the backside electrode film of the other of the mutually-adjacent solar cells to allow the solar cells to be connected in series to one another, for example. Further, a surface electrode is provided on the transparent electrode film of the solar cell located at each end, and the surface electrodes are connected to a terminal box through respective tub lines to collect electric power generated by the solar cells and take out the electric power therefrom to the outside.

### PRIOR ART DOCUMENT

### PATENT DOCUMENT

Patent Document 1: Japanese Unexamined Patent Application Publication No. 2009-295744
Patent Document 2: Japanese Unexamined Patent Application Publication No. 2012-9753

### SUMMARY OF THE INVENTION

It is desirable to provide a wiring member capable of achieving good connection between a photovoltaic device and a terminal of a terminal box in the thin-film photovoltaic device, a solar cell module in which the wiring member is used, and a method of manufacturing a solar cell module.

To solve the above-described problem, a wiring member according to an embodiment of the invention includes: a conductor having a first face and a second face that is located opposite to the first face; a first layer provided on the first face of the conductor, and containing a flux component and an anti-corrosive component; and a second layer provided on the second face of the conductor, and including an adhesive.

A solar cell module according to an embodiment of the invention includes: a photovoltaic device having a surface electrode; a terminal box allowing electric power generated by the photovoltaic device to be taken out to outside; and a wiring member electrically connecting the surface electrode of the photovoltaic device to the terminal box. The wiring member includes: a conductor having a first face and a second face that is located opposite to the first face; a first layer provided on the first face of the conductor, and containing a flux component and an anti-corrosive component; and a second layer provided on the second face of the conductor, and including an adhesive.

A method of manufacturing a solar cell module according to an embodiment of the invention includes: forming a wiring member through providing a first layer on a first face of a conductor and a second layer on a second face of the conductor, wherein the second face is located opposite to the first face, the first layer contains a flux component and an anti-corrosive component, and the second layer includes an adhesive; and connecting one end of the wiring member to a surface of a photovoltaic device via the second layer, and connecting the wiring member to a terminal box via the first layer, wherein the terminal box allows electric power generated by the photovoltaic device to be taken out to outside.

According to one embodiment of the invention, the wiring member may be connected by soldering via the first layer to the terminal box that allows the electric power collected from the photovoltaic device to be taken out, for example. Here, the wiring member is formed with the first layer that contains a flux component and a component having an anti-corrosion function, making it possible to improve wettability of a solder and thus to perform the soldering connection promptly and with certainty. Also, because a photovoltaic device may be sealed by a translucent sealant such as EVA, the wiring member may be placed under acetic acid gas atmosphere resulting from an increase in temperature of a solar cell module, thus bringing about a concern of corrosion; however, the first layer also contains the anti-corrosive component, making it possible to prevent the corrosion as well.

### BRIEF DESCRIPTION OF THE DRAWINGS

[FIG. 1A] is a perspective view illustrating a tub line and a thin-film photovoltaic device to each of which one embodiment of the invention is applied.
[FIG. 1B] is a plan view illustrating the tub line and the thin-film photovoltaic device to each of which one embodiment of the invention is applied.
[FIG. 2] is an exploded perspective view illustrating a solar cell module to which one embodiment of the invention is applied.
[FIG. 3] is a cross-sectional view illustrating the tub line to which one embodiment of the invention is applied.
[FIG. 4] is a cross-sectional view illustrating an adhesive.
[FIG. 5] is a cross-sectional view illustrating the tub line in which a conductive adhesion film is used as the adhesive.
[FIG. 6] is a plan view illustrating the solar cell module to which the tub line is attached, where a sealant and a back sheet are unillustrated.
[FIG. 7] is an exploded perspective view illustrating a substrate-type solar cell module to which one embodiment of the invention is applied.
[FIG. 8] is an exploded perspective view illustrating another solar cell module to which one embodiment of the invention is applied.
[FIG. 9] is a cross-sectional view illustrating a connection section at which a collector tub line and a connection tub line are connected together.
[FIG. 10] is a cross-sectional view illustrating a connection section at which the collector tub line and the connection tub line are connected together.
[FIG. 11] is an exploded perspective view illustrating an example of a thin-film photovoltaic device according to a reference example.
[FIG. 12A] is a plan view illustrating an example of the thin-film photovoltaic device according to the reference example.
[FIG. 12B] is a cross-sectional view of an electrode terminal of the thin-film photovoltaic device illustrated in FIG. 12A.

### DESCRIPTION OF EMBODIMENTS

In the following, a wiring member, a solar cell module in which the wiring member is used, and a method of manufacturing a solar cell module, to each of which one embodiment of the invention is applied, are described in detail with reference to the accompanying drawings. Note that the invention is not limited only to the following embodiments, and various modifications are possible within a scope not departing from the gist of the invention. Also, the drawings are schematic and may be different in factors such as proportions of respective dimensions from the actual ones. Specific dimensions, etc., should be determined taking the following description into account. Further, a relationship as to dimensions and a proportion of dimensions may also differ between the mutual drawings.

### [Solar Cell Module]

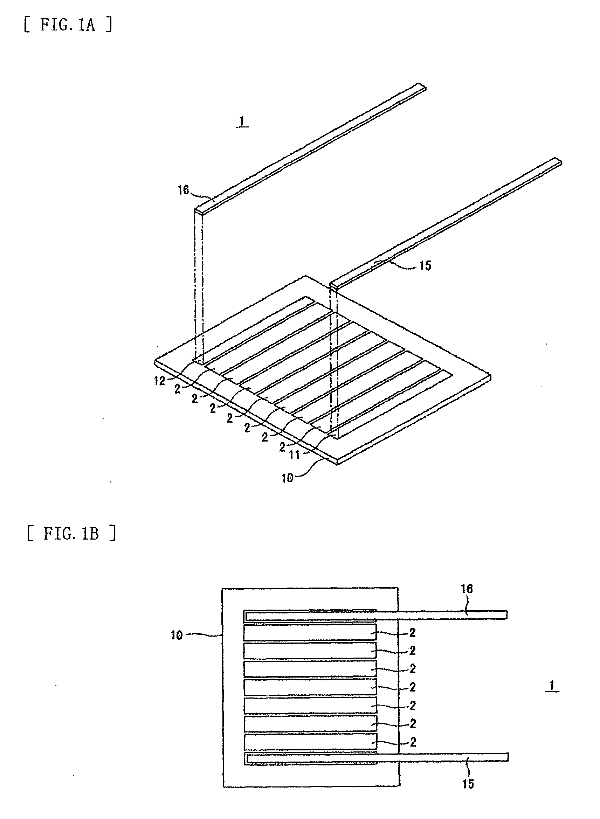

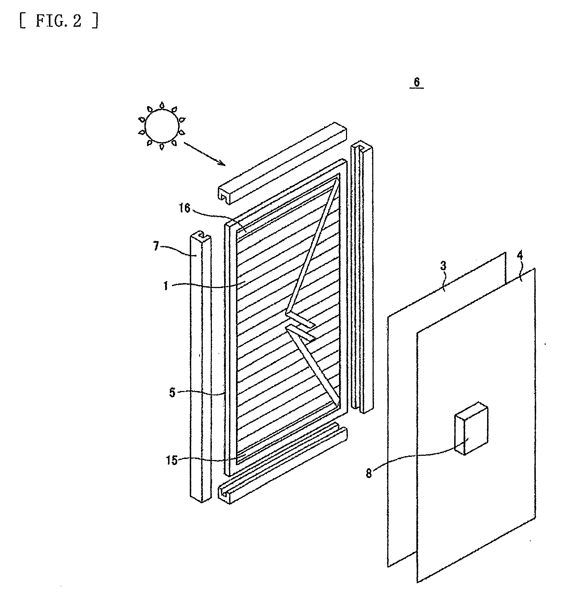

Referring to FIGs. 1A and 1B, a thin-film photovoltaic device 1, to which one embodiment of the invention is applied, structures a solar cell string in which a plurality of solar cells 2 are connected to each other through a contact line. As illustrated in FIG. 2, the thin-film photovoltaic device 1 having the string structure may be formed on a glass substrate serving as a front side cover 5, and a sealing adhesive sheet 3 and a back sheet 4 are stacked and collectively laminated on the backside thereof, for example. Thereafter, a metal frame 7 made of aluminum or the like is attached to the surrounding thereof as appropriate followed by providing on the back sheet 4 a terminal box 8 for taking out electric power collected from the thin-film photovoltaic device 1, whereby a solar cell module 6 is formed.

For example, a translucent sealant such as ethylene vinyl acetate copolymer resin (EVA) may be used for the sealing adhesive. Also, usable example of the back sheet 4 may include a glass and a laminator in which an aluminum film is held between resin films. Note that, besides forming the thin-film photovoltaic device 1 on the glass substrate serving as the front side cover 5, the front side cover 5 and the thin-film photovoltaic device 1 may be provided separately and sealing adhesive sheets 3 disposed on respective front and back sides of the thin-film photovoltaic device 1 may be used for laminate sealing between the front side cover 5 and the back sheet 4 in the solar cell module 6. In this case, a translucent material such as a glass and a translucent plastic may be used for the front side cover 5, for example.

### [Solar Cell]

The thin-film photovoltaic device 1 may be a superstrate-type photovoltaic device in which a transparent electrode film made of a transparent conductive film, a photoelectric conversion layer, and a backside electrode film, which are unillustrated, are stacked in this order on a translucent insulating substrate 10 and in which light is incident from the translucent insulating substrate 10 side. Note that the thin-film photovoltaic device can also be a substrate-type photovoltaic device in which a base, a backside electrode, a photoelectric conversion layer, and a transparent electrode are formed in this order. In the following, a description is given of the superstrate-type thin-film photovoltaic device 1 as an example, but the technology may also be used for the substrate-type thin-film photovoltaic device as described later.

A glass or a heat resistant resin such as polyimide may be used for the translucent insulating substrate 10. Also, the translucent insulating substrate 10 may serve as the front side cover 5 as well in the thin-film photovoltaic device 1 as described above.

Usable examples of the transparent electrode film may include SnO₂, ZnO, and ITO. Usable examples of the photoelectric conversion layer may include: a silicon-based photoelectric conversion film made of amorphous silicon, microcrystalline silicon, polycrystalline silicon, or the like; and a compound-based photoelectric conversion film made of CdTe, CuInSe₂, Cu (In, Ga) Se₂, or the like.

The backside electrode film may have a structure in which a transparent conductive film and a metal film are stacked, for example. Usable examples of the transparent conductive film may include SnO₂, ZnO, and ITO. Usable examples of the metal film may include silver and aluminum.

As illustrated in FIG. 1A, the thus-configured thin-film photovoltaic device 1 is formed with the plurality of solar cells 2 each having a rectangular shape and a length extending substantially across the overall width of the translucent insulating substrate 10. Each of the solar cells 2 is separated from each other by an electrode dividing line, and the transparent electrode film of one of the mutually-adjacent solar cells 2 and 2 and the backside electrode film of the other of the mutually-adjacent solar cells 2 and 2 are connected to each other by the contact line. In this manner, the solar cell string is configured in which the solar cells 2 are connected in series to one another.

In addition, on the transparent electrode film of the solar cell 2 located at one end of the solar cell string is a P-type electrode terminal 11 that is linear in shape and having substantially the same length as the solar cell 2. On the backside electrode film of the solar cell 2 located at the other end of the solar cell string is an N-type electrode terminal 12 that is linear in shape and having substantially the same length as the solar cell 2. In the thin-film photovoltaic device 1, the P-type electrode terminal 11 and the N-type electrode terminal 12 serve as respective electrode taking-out sections, allowing electric power to be fed to the terminal box 8 via a positive tub line 15 and a negative tub line 16.

### [Tub Line (Wiring Member)]

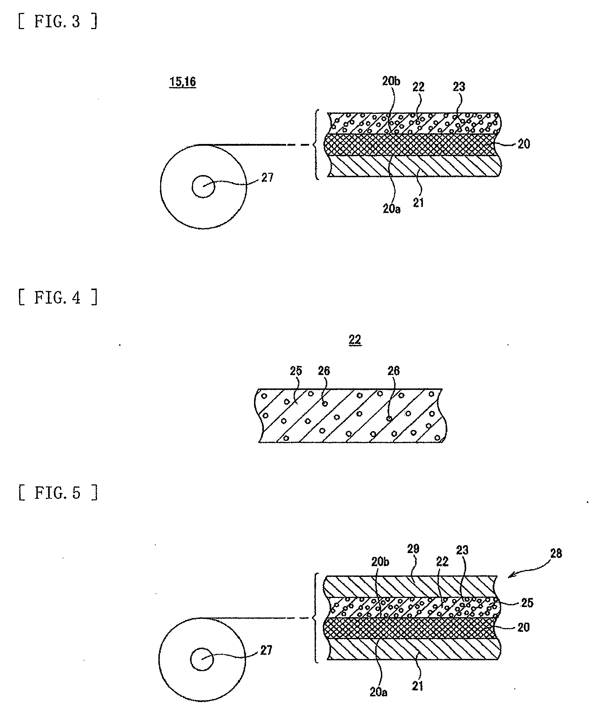

Referring to FIG. 3, the positive tub line 15 and the negative tub line 16 each include a conductor 20, a first layer 21, and a second layer 23. The first layer 21 is provided on one face 20a (a first face) of the conductor 20, and including a mixture of a flux and a liquid having an anti-corrosion function. The second layer 23 is provided on the other face 20b (a second face) of the conductor 20, and including an adhesive 22. The second layers 23 serve to connect the P-type electrode terminal 11 and the N-type electrode terminal 12 formed on the thin-film photovoltaic device 1 to the respective conductors 20 of the positive tub line 15 and the negative tub line 16.

Each of the positive tub line 15 and the negative tub line 16 may be configured to be connected by soldering via the first layer 21 to the terminal box 8 that serves to take out electric power collected from each of the P-type electrode terminal 11 and the N-type electrode terminal 12 to the outside.

The conductor 20 is a rectangular wire having a width in a range from 1 mm to 3 mm substantially the same as a width of each of the P-type electrode terminal 11 and the N-type electrode terminal 12, and may be formed through performing a slitting process of a copper foil or an aluminum foil that may be rolled to a thickness in a range from 50 µm to 300 µm or through rolling a thin metal wire made of copper, aluminum, or the like into a flat shape, for example. The one face (S face) 20a of the conductor 20 is formed entirely with the first layer 21 that includes a liquid in which a flux and an anti-corrosive ink are mixed, and the other face (M face) 20b is formed entirely with the second layer 23 that includes the adhesive 22.

### [First Layer]

The first layer 21 is formed through mixing the flux and the liquid having the anti-corrosion function and coating the one face 20a of the conductor 20 entirely with the mixture. In other words, the first layer has a flux component and an anti-corrosive component. For example, a lead-free solder may be used for the flux. For the liquid having the anti-corrosion function, an anti-corrosive ink such as black ink containing pigment-based carbon black and fluororesin-based ink may be used, for example.

The first layer 21 is formed to a predetermined thickness through coating, using a wire bar or the like, the one face 20a of the conductor 20 with the liquid in which the flux and the anti-corrosive ink are mixed followed by volatilizing a solvent using an oven.

The positive tub line 15 and the negative tub line 16 are each configured to be connected by soldering via the first layer 21 to a connection terminal of the terminal box 8 that serves to take out electric power collected from the thin-film photovoltaic device 1. Here, the first layer 21 includes the flux component, making it possible to improve wettability of a solder and thus to perform the soldering connection promptly and with certainty. Also, because the thin-film photovoltaic device 1 may be sealed by a translucent sealant such as EVA, the thin-film photovoltaic device 1 may be placed under acetic acid gas atmosphere resulting from an increase in temperature of the solar cell module 6, thus bringing about a concern of corrosion of the tub lines; however, the first layer 21 also contains the anti-corrosive component, making it possible to prevent the corrosion as well.

### [Mixing Ratio]

A mixing ratio in solid content of the flux to the anti-corrosive ink may be preferably defined as: (flux) : (anti-corrosive ink) = 1:3 to 3:1 both inclusive, and more preferably defined as: (flux) : (anti-corrosive ink) = 1:1 to 2:1 both inclusive or defined as: (flux) : (anti-corrosive ink) = 1:1 to 1:2 both inclusive in particular. A material other than the flux and the anti-corrosive ink may be used as long as the flux component and the anti-corrosive component are contained, and as long as the mixing ratio in solid content of the flux component to the anti-corrosive component is defined as: (flux component) : (anti-corrosive component) = 1:3 to 3:1 both inclusive.

If the solid content of the flux is more than and the solid content of the anti-corrosive ink is less than the range defined by (flux) : (anti-corrosive ink) = 1:3 to 3:1 both inclusive, resistance to corrosion may deteriorate. The appearance may also be impaired especially in the substrate-type thin-film photovoltaic device in which the positive tub line 15 and the negative tub line 16 are connected on the light-receiving surface side, because less solid content of the anti-corrosive ink makes a black color lighter, which in turn causes a color of copper of the conductor 20 to be appeared on a black ground color of a CIS-based thin-film photovoltaic device or a CIGS-based thin-film photovoltaic device, for example. Also, if the solid content of the flux is less than and the solid content of the anti-corrosive ink is more than the range described above, the wettability of a solder may be deteriorated, preventing the soldering connection from being performed promptly and with certainty on the connection terminal of the terminal box 8, and thus increasing connection resistance.

In contrast, allowing the solid content of the flux and the solid content of the anti-corrosive ink to fall within the range described above prevents the deterioration in the resistance to corrosion and the decrease in appearance properties. Also, the black color derived from the anti-corrosive ink in each of the positive tub line 15 and the negative tub line 16 disposed on the light-receiving surface side absorbs ultraviolet rays in this range, making it possible to improve resistance to weather (resistance to light) of the solar cell module. Further, this also increases the wettability of the solder, making it possible to perform the soldering connection promptly and with certainty.

### [Thickness of First Layer 21]

A thickness of the first layer 21 may be preferably in a range from 1 µm to 10 µm both inclusive, more preferably in a range from 1 µm to 8 µm both inclusive, and, in particular, more preferably in a range from 3 µm to 5 µm both inclusive. The connection resistance tends to increase as the thickness of the first layer 21 increases, and in reverse, the resistance to corrosion and the appearance tend to deteriorate as the thickness thereof decreases.

### [Second Layer (Adhesive 22)]

Next, a description is given of the second layer 23. The adhesive 22 that configures the second layer 23 serves to connect the positive tub line 15 and the negative tub line 16 to the P-type electrode terminal 11 and the N-type electrode terminal 12, respectively. Usable examples of the adhesive 22 may include a conductive adhesion paste and a conductive adhesion film. The second layer 23 may be formed through coating the other face 20b of the conductor 20 with the conductive adhesion paste, or attaching the conductive adhesion film to the other face 20b of the conductor 20.

### [Conductive Adhesion Paste]

Referring to FIG. 4, the adhesive 22 may have a configuration in which conductive particles 26 are contained densely in a thermosetting binder resin layer 25. Also, a minimum melt viscosity of the binder resin in the adhesive 22 may be preferably in a range from 100 Pa·s to 100000 Pa·s in terms of a pressing property. If the minimum melt viscosity is excessively low, a resin of the adhesive 22 may flow in the course of processes from light pressure bonding to complete curing, making it easier to cause connection failure or squeezing out of the resin onto a light-receiving surface of a cell and causing a reduction in light-receiving rate. Also, excessively high minimum melt viscosity may also cause easier occurrence of defect upon attachment of the film and thus may affect reliability of connection in some cases. Note that the minimum melt viscosity may be measured by loading a rotary viscometer with a given amount of a sample and measuring viscosity while increasing a temperature at a predetermined rate of temperature increase.

The conductive particles 26 used for the adhesive 22 are not particularly limited, examples of which may include: particles of metal such as nickel, gold, silver, and copper; particles obtained by applying gold plating or the like to resin particles; and particles obtained by applying insulation coating to outermost layers of the respective gold-plated resin particles.

A viscosity around room temperature of the adhesive 22 may be preferably in a range from 10 kPa·s to 10000 kPa·s both inclusive, and more preferably in a range from 10 kPa·s to 5000 kPa·s both inclusive. The viscosity in the range from 10 kPa·s to 10000 kPa·s both inclusive makes it possible to prevent so-called blocking resulting from squeezing out, in a case where the adhesive 22 is provided on the other face 20b of the conductor 20 and winding is performed around a reel 27, and also to maintain predetermined tack force.

A composition of the binder resin layer 25 of the adhesive 22 is not particularly limited as long as the properties described above are not impaired; however, it is more preferable that the binder resin layer 25 contain a film forming resin, a liquid epoxy resin, a latent curing agent, and a silane coupling agent.

The film forming resin may be equivalent to a high molecular weight resin whose average molecular weight is equal to or more than 10000, and may preferably have average molecular weight of about 10000 to about 80000 in terms of film forming properties. Various resins may be used for the film forming resin, examples of which may include an epoxy resin, a modified epoxy resin, a urethane resin, and a phenoxy resin. In particular, the phenoxy resin may be suitably used in terms of factors such as a film formation state and the connection reliability.

The liquid epoxy resin is not particularly limited and any commercially-available epoxy resin is useable as long as the resin has fluidity at room temperature. Specific examples of such an epoxy resin may include a naphthalene-type epoxy resin, a biphenyl-type epoxy resin, a phenol-novolac-type epoxy resin, a bisphenol-type epoxy resin, a stilbene-type epoxy resin, a triphenolmethane-type epoxy resin, a phenolaralkyl-type epoxy resin, a naphthol-type epoxy resin, a dicyclopentadiene-type epoxy resin, and a triphenylmethane-type epoxy resin. These epoxy resins may be used alone or in combination of two or more of them. Also, they may be used in combination as appropriate with any other organic resin such as an acrylic resin.

Various curing agents may be used for the latent curing agent, examples of which may include a heating-curable-type curing agent and an ultraviolet-curable-type curing agent. The latent curing agent does not undergo reaction under normal circumstances, and is activated by a certain trigger to start reaction. The trigger may be heat, light, or application of pressure, and may be used selectively depending on applications. In particular, the heating-curable-type latent curing agent may be suitably used in the present embodiment, which is completely cured by being pressed, while being heated, onto the P-type electrode terminal 11 or the N-type electrode terminal 12. In a case where the liquid epoxy resin is used, the latent curing agent including imidazoles, amines, sulfonium salt, onium salt, or the like may be used.

Usable examples of the silane coupling agent may include an epoxy-based silane coupling agent, an animo-based silane coupling agent, a mercapto-sulfide-based silane coupling agent, and a ureide-based silane coupling agent. In particular, the epoxy-based silane coupling agent may be suitably used in the present embodiment. This makes it possible to improve adhesion properties at an interface between an organic material and an inorganic material.

Also, an inorganic filler may be preferably contained as any other additive composition. Containing the inorganic filler makes it possible to adjust the fluidity of the resin layer upon pressure bonding and to improve a capture factor of the particles. Usable examples of the inorganic filler may include silica, talc, titanium oxide, calcium carbonate, and magnesium oxide. However, the inorganic filler is not particularly limited in kind.

The adhesive 22 may be formed through dissolving the conductive particles 26, the film forming resin, the liquid epoxy resin, the latent curing agent, and the silane coupling agent into a solvent. Usable examples of the solvent may include toluene, ethyl acetate, and a combined solvent thereof. The other face 20b of the conductor 20 is coated with a conductive paste obtained by the dissolving, following which volatilization of the solvent is performed to form the second layer 23. The conductor 20 on which the second layer 23 and the first layer 21 are formed may be wound around the reel 27 as illustrated in FIG. 3 to be stored, and may be drawn out from the reel 27 at a predetermined length upon the actual use to be used as the positive tub line 15 and the negative tub line 16.

Thereafter, heat-pressurization of the positive tub line 15 and the negative tub line 16 is performed at a predetermined temperature and a predetermined pressure using a heating-pressing head, a vacuum laminator, or the like while the positive tub line 15 and the negative tub line 16 are temporarily attached onto the P-type electrode terminal 11 and the N-type electrode terminal 12, respectively. This fluidizes the binder resin of the adhesive 22 to fill a region between the P-type electrode terminal 11 and the conductor 20 of the positive tub line 15 and a region between the N-type electrode terminal 12 and the conductor 20 of the negative tub line 16, and to cause the conductive particles 26 to be held between the tub lines (the positive tub line 15 and the negative tub line 16) and the respective electrode terminals (the P-type electrode terminal 11 and the N-type electrode terminal 12). In this state, the binder resin is cured, thus making it possible for the adhesive 22 to adhere the tub lines onto the respective electrode terminals and to electrical connect the tub lines to the respective electrode terminals.

### <Conductive Adhesion Tape>

Besides using the conductive paste, the conductive adhesion film may be used for the adhesive 22, which may be attached to the other face 20b of the conductor 20. Such a conductive adhesion film 28 may have a configuration in which the binder resin layer 25 is stacked on a base film 29 and may be formed to have a tape-like shape as illustrated in FIG. 5 as in a case of the conductor 20. The base film 29 is not particularly limited, usable examples of which may include PET (Poly Ethylene Terephthalate), OPP (Oriented Polypropylene), PMP (Poly-4-methlpentene-1), and PTFE (Polytetrafluoroethylene).

In a case of using the conductive adhesion film 28, the base film 29 described above is attached as a cover film onto the binder resin layer 25. In this manner, the conductive adhesion film 28 is stacked on the other face 20b of the conductor 20 to allow them to be integrated with each other in advance. Thus, upon the actual use, the base film 29 is peeled to attach the binder resin layer 25 of the conductive adhesion film 28 onto the P-type electrode terminal 11 and the N-type electrode terminal 12, allowing for temporal attachment of the positive tub line 15 and the negative tub line 16 to the respective electrode terminals (the P-type electrode terminal 11 and the N-type electrode terminal 12). Thereafter, heat-pressurization similar to that in a case of the conductive paste is performed to cure the binder resin layer 25.

In a case where the second face of each of the positive tub line 15 and the negative tub line 16 has an irregular surface having a plurality of minute projections, an insulating adhesive such as an insulating adhesion film and an insulating adhesion paste may be used for the connection of the P-type electrode terminal 11 to the positive tub line 15 and the connection of the N-type electrode terminal 12 to the negative tub line 16, instead of the conductive adhesion paste or the conductive adhesion film 28 described above. In this case, the minute projections of the second face come into contact with a surface electrode of the photovoltaic device to establish electrical conduction, and a region thereof in which the minute projections do not come into contact is filled with the insulating adhesive. The insulating adhesion film and the insulating adhesion paste have respective configurations similar to those of the conductive adhesion film and the conductive adhesion paste, with the exception that the conductive particles are not contained in the binder resin layer.

### [Manufacturing Process of Tub Line]

Next, a description is given of a manufacturing process of each of the positive tub line 15 and the negative tub line 16. First, a metal foil that serves eventually as the conductor 20 is prepared. For example, the metal foil may be a copper foil, an aluminum foil, or the like, and may have a thickness in a range from 50 µm to 300 µm. Specific examples of a method for manufacturing the metal foil may include a method in which a metal is rolled and a method in which a metal is precipitated using an electrolytic plating. One face (a shiny face) of the metal foil is coated with the liquid mixed with the flux and the anti-corrosive ink using the wire bar or the like, following which the resultant is dried to form the first layer 21. Then, the other face (a matte face) of the metal foil is coated with the conductive adhesion paste using the wire bar or the like, followed by drying of the resultant, or the conductive adhesion film 28 is stacked thereon to allow the conductive adhesion film 28 to be integrated therewith, to form the second layer 23 that includes the adhesive 22.

Then, a slitting process is performed on the rolled metal foil to obtain the positive tub line 15 and the negative tub line 16 in each of which the first layer 21 is formed on the one face 20a of the tape-shaped conductor 20 and the second layer 23 is formed on the other face 20b.

The positive tub line 15 and the negative tub line 16 each may also be obtained through rolling a thin metal wire made of copper, aluminum, or the like into a flat shape, or performing slitting of a rolled metal foil, to obtain the tape-shaped conductor 20, and forming the first layer 21 and the second layer 23 thereafter.

The tape-shaped positive tub line 15, or the tape-shaped negative tub line 16, may be wound around the reel 27 as illustrated in FIG. 3 to be stored, and may be drawn out from the reel 27 and cut to a necessary length to be provided for the connection to the electrode terminals (the P-type electrode terminal 11 and the N-type electrode terminal 12) upon use, for example. Here, in each of the positive tub line 15 and the negative tub line 16, the first layer 21 including the flux and the anti-corrosive ink is formed entirely on the one face 20a of the conductor 20, and the second layer 23 including the adhesive 22 is formed entirely on the other face 20b of the conductor 20, making it possible for any portion thereof drawn out from the reel to be provided for the connection to the electrode terminals on the surface of the thin-film photovoltaic device 1, and also for the connection to the connection terminal of the terminal box 8.

### [First Connection Style of Tub Line]

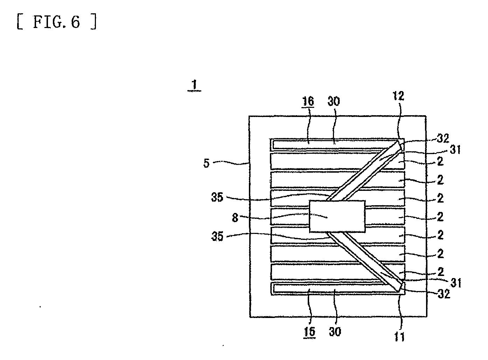

Referring to FIG. 6, the positive tub line 15 and the negative tub line 16 described above each include a collector tub section 30 and a connection tub section 31. The collector tub sections 30 are connected to the respective P-type electrode terminal 11 and N-type electrode terminal 12 via the respective adhesives 22, and collect electric power from the respective electrode terminals (the P-type electrode terminal 11 and the N-type electrode terminal 12). The connection tub sections 31 each extend to the terminal box 8, and are each connected to the connection terminal of the terminal box 8. The collector tub section 30 and the connection tub section 31 are continuous with respect to each other via a bent section 32.

The collector tub section 30 is a region between the bent section 32 and the end of one of the positive tub line 15 and the negative tub line 16. The collector tub section 30 is connected electrically and mechanically to the P-type electrode terminal 11 or the N-type electrode terminal 12 via the adhesive 22 of the second layer 23 formed on the other face 20b of the conductor 20. The connection tub section 31 is a region between the bent section 32 and the end of the other of the positive tub line 15 and the negative tub line 16. The connection tub section 31 extends along the surface of the thin-film photovoltaic device 1, and is penetrated through the sealing adhesive sheet 3 and the back sheet 4 (FIG. 2) to be guided to the connection terminal of the terminal box 8 disposed on the back sheet 4. A tip section of the connection tub section 31 is connected by soldering to the connection terminal of the terminal box 8 via the first layer 21 formed on the one face 20a of the conductor 20.

The bent section 32 is a boundary that defines the collector tub section 30 and the connection tub section 31, but the collector tub section 30 and the connection tub section 31 are continuous with respect to each other via the bent section 32, allowing each of the positive tub line 15 and the negative tub line 16 to have a seamless structure without any joint section. This makes it possible to prevent factors such as an increase in resistance value attributable to concentration of charges on a joint, a decrease in connection reliability of a joint section, and a damage of the translucent insulating substrate 10 attributable to concentration of heat or a stress on the joint section.

The connection tub section 31 is provided to extend on the surface of the thin-film photovoltaic device 1; however, the one face 20a of the conductor 20 is covered with an insulating film 35, allowing for prevention of short-circuit by virtue of the insulating film 35 even when the connection tub section 31 is brought into contact with an electrode film of the thin-film photovoltaic device 1.

It is also possible for the connection tub section 31 to prevent the short-circuit from occurring with respect to the electrode film of the thin-film photovoltaic device 1 without using the insulating film 35 by providing the first layer 21 with an insulating property, which may be achieved by using, for the anti-corrosive ink that structures the first layer 21, a non-conductive black ink that contains carbon black and whose pH level is adjusted, for example. Hence, it is possible for the positive tub line 15 and the negative tub line 16 to be provided for the connection to the respective electrode terminals (the P-type electrode terminal 11 and the N-type electrode terminal 12) on the surface of the thin-film photovoltaic device 1 and also for the connection to the connection terminal of the terminal box 8, at any portion thereof drawn out from the reel 27.

As illustrated in FIG. 2, in a case where the positive tub line 15 and the negative tub line 16 are used in the superstrate-type thin-film photovoltaic device 1, the collector tub sections 30 thereof are connected to the respective P-type electrode terminal 11 and N-type electrode terminal 12, following which the connection tub sections 31 beyond the respective bent sections 32 are each arranged on the surface of the thin-film photovoltaic device 1 via the insulating film 35 on an as-necessary basis, and are each inserted through the sealing adhesive sheet 3 such as EVA and the back sheet 4 to be connected by soldering to the connection terminal of the terminal box 8 disposed on the back sheet 4.

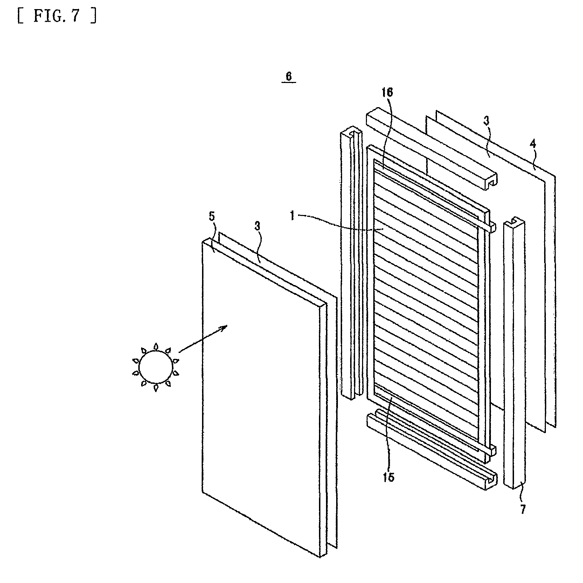

Also, in a case where the positive tub line 15 and the negative tub line 16 are used in the substrate-type thin-film photovoltaic device 1, the collector tub sections 30 thereof are connected to the respective P-type electrode terminal 11 and N-type electrode terminal 12, following which the connection tub sections 31 beyond the respective bent sections 32 are each arranged on the backside of the thin-film photovoltaic device 1, and are each inserted through the sealing adhesive sheet 3 such as EVA and the back sheet 4 to be connected by soldering to the connection terminal of the terminal box 8 disposed on the back sheet 4, as illustrated in FIG. 7.

In the positive tub line 15 and the negative tub line 16, the collector tub sections 30 are connected on the respective electrode terminals (the P-type electrode terminal 11 and the N-type electrode terminal 12), the connection tub sections 31 are arranged on the surface of the thin-film photovoltaic device 1, and the tip sections thereof are each inserted through a through hole formed through the sealing adhesive sheet 3 and the back sheet 4. Thereafter, the positive tub line 15 and the negative tub line 16 are connected to the respective electrode terminals using the vacuum laminator, and a batch laminating-sealing process is performed using the sealing adhesive sheet 3 between the front side cover 5 and the back sheet 4.

Then, the metal frame 7 may be placed around the thin-film photovoltaic device 1, following which the tip portions of the respective connection tub sections 31, having inserted through the back sheet 4, of the positive tub line 15 and the negative tub line 16 are connected by soldering to the connection terminal of the terminal box 8 provided on the back sheet 4, thereby completing the solar cell module 6.

In the solar cell module 6 according to the present embodiment as described above, the first layer 21 of each of the positive tub line 15 and the negative tub line 16 includes the flux, making it possible to improve the wettability of the solder and thus to perform the soldering connection promptly and with certainty. Also, because the thin-film photovoltaic device 1 may be sealed by the translucent sealant such as EVA, the thin-film photovoltaic device 1 may be placed under acetic acid gas atmosphere resulting from an increase in temperature of the solar cell module 6, thus bringing about a concern of corrosion of the positive tub line 15 and the negative tub line 16; however, the first layer 21 also contains the liquid having the anti-corrosion function, making it possible to prevent the corrosion of the connection tub sections 31 of the respective tub lines (the positive tub line 15 and the negative tub line 16) arranged on the surface of the thin-film photovoltaic device 1 as well.

### [Reference Example]

A description is now given in greater detail of effects achieved by the solar cell module 6 according to the present embodiment in comparison to a reference example.

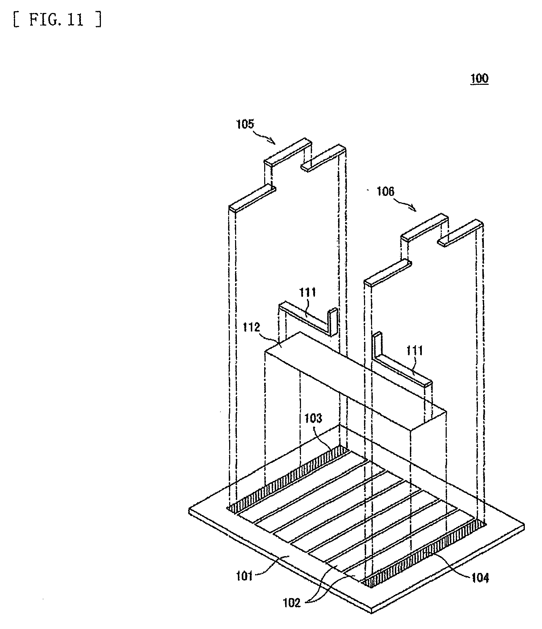

FIG. 11 illustrates a configuration example of a thin-film photovoltaic device that structures a solar cell string according to a reference example. Such a thin-film photovoltaic device 100 includes a plurality of solar cells 102 in each of which a transparent electrode film made of a transparent conductive film, a photoelectric conversion layer, and a backside electrode film, which are unillustrated, are stacked on a translucent insulating substrate 101. Each of the solar cells 102 has an elongated strip shape, and has a length extending substantially across the overall width of the translucent insulating substrate 101. Also, the thin-film photovoltaic device 100 has a configuration in which the transparent electrode film of one of the mutually-adjacent solar cells 102 and 102 is connected to the backside electrode film of the other of the mutually-adjacent solar cells to allow the solar cells 102 to be connected in series to one another.

A P-type electrode terminal 103 that is linear in shape and having substantially the same length as the solar cell 102 is formed on the transparent electrode film of the solar cell 102 located at one end of the thin-film photovoltaic device 100, whereas an N-type electrode terminal 104 that is linear in shape and having substantially the same length as the solar cell 102 is formed on the backside electrode film of the solar cell 102 located at the other end thereof. Those P-type electrode terminal 103 and the N-type electrode terminal 104 serve as respective electrode taking-out sections.

In the P-type electrode terminal 103, a positive collector tub line 105 made of a copper foil is joined electrically and mechanically to the entire surface of the P-type electrode terminal 103 referred to as a bus bar. Similarly, in the N-type electrode terminal 104, a negative collector tub line 106 made of a copper foil is joined electrically and mechanically to the entire surface of the N-type electrode terminal 104. In general, soldering is performed as a way of joining them.

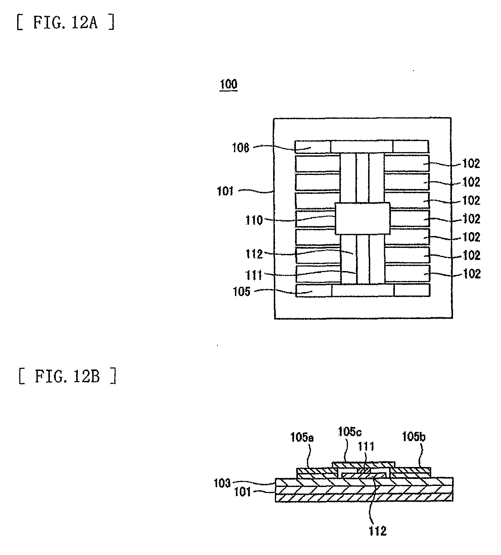

Referring to FIG. 12A, a back surface of the thin-film photovoltaic device 100 is connected with a terminal box 110 and a terminal box tub line 111. The terminal box 110 is connected to the P-type electrode terminal 103 and the N-type electrode terminal 104, and outputs electric power to the outside. The terminal box tub line 111 connects the terminal box 110 to the P-type electrode terminal 103 and the N-type electrode terminal 104.

The terminal box 110 is fixed in the center of the back surface of the thin-film photovoltaic device 100 by an adhesive, and a sealing resin such as EVA and a back sheet, which are unillustrated, are provided between the thin-film photovoltaic device 100 and the terminal box 110. The terminal box tub line 111 is made of an elongated copper foil or an elongated A1 film as with the positive collector tub line 105 and the negative collector tub line 106 described above, and is arranged on the back surface of the thin-film photovoltaic device 100 with an insulating tape 112 interposed in between.

The terminal box tub line 111 has one end inserted through the sealing resin and the back sheet to be connected by soldering to the terminal box 110 arranged on the back sheet, and the other end arranged on the P-type electrode terminal 103 or the N-type electrode terminal 104 via the insulating tape 112.

Referring to FIG. 12B, a connection section at which the terminal box tub line 111 and the positive collector tub line 105 are connected together includes a first positive collector tub line 105a, a second positive collector tub line 105b, and a third positive collector tub line 105c. The third positive collector tub line 105c is so connected to the first positive collector tub line 105a and the second positive collector tub line 105b at both sides interposing the insulating film 112 and the terminal box tub line 111 in between as to stride over the insulating tape 112 and the terminal box tub line 111 from the first positive collector tub line 105a to the second positive collector tub line 105b. Further, the third positive collector tub line 105c is connected to the terminal box tub line 111. The connections between the first positive collector tub line 105a and the third positive collector tub line 105c and the second positive collector tub line 105b and the third positive collector tub line 105c (two locations), and the connection between the third positive collector tub line 105c and the terminal box tub line 111 (one location), are performed by ultrasonic solder joining. The same applies to the connections between the negative collector tub line 106 and the terminal box tub line 111.

In the thin-film photovoltaic device 100, however, various materials such as Al, Ag, and ZnO are used for the P-type electrode terminal 103 and the N-type electrode terminal 104 in accordance with manufacturing methods, configurations, and so forth, preventing connection strength with respect to the positive collector tub line 105 and the negative collector tub line 106 from being maintained by the solder depending on materials. This may incur an increase in connection resistance value and a decrease in power generation efficiency.

Also, heat history in a high-temperature range resulting from the soldering connection is applied locally upon the connections between the first positive collector tub line 105a and the third positive collector tub line 105c and the second positive collector tub line 105b and the third positive collector tub line 105c, and the connection between the third positive collector tub line 105c and the terminal box tub line 111, causing warpage of the translucent insulating substrate 101 made of a glass or the like or damage in some cases.

Hence, a method has been proposed in which a tub line is connected using a resin adhesive in place of the soldering connection. For such a resin adhesive, a film-shaped resin adhesive is used in which spherical conductive particles each having a mean particle diameter of a few µm order are dispersed in a thermosetting binder resin composition, for example. In this method, a resin adhesive thermally cured at a temperature lower than a melting temperature of a solder is disposed between the tub line and a P-type electrode terminal and between the tub line and an N-type electrode terminal, and heat-pressurization is applied to the tub lines from above to make connection.

In particular, using an adhesive-equipped tub line in which a resin adhesive layer is stacked on a surface in advance allows for elimination of an arrangement process step of the resin adhesive, which is effective in simplification of a manufacturing process.

However, when performing soldering connection of the tub line, in which the resin adhesive layer is stacked on the surface, to a terminal of a terminal box, it is necessary to remove the resin adhesive layer to expose a metal film, or it is necessary to so form in advance the adhesive-equipped tub line as to stack the resin adhesive layer excluding a portion to be connected to the terminal of the terminal box. This makes a manufacturing process of the solar cell module in which the adhesive-equipped tub line is used and a manufacturing process of the adhesive-equipped tub line cumbersome and complicated.

In contrast, in the solar cell module 6 according to the present embodiment, the collector tub section 30 and the connection tub section 31 are continuous with respect to each other via the bent section 32, allowing each of the positive tub line 15 and the negative tub line 16 to have a seamless structure without any joint section. Also, the second layer 23 including the adhesive 22 is connected to the P-type electrode terminal 11 or the N-type electrode terminal 12 of the thin-film photovoltaic device 1, and the first layer 21 is connected to the terminal box. Hence, unlike the reference example described above, the process of joining the tub lines together is unnecessary, making it possible to simplify a manufacturing process. Also, unlike the reference example described above, various issues, such as the increase in resistance value attributable to the concentration of charges on the joint of the mutual tub lines as well as the resulting decrease in power generation efficiency, the decrease in connection reliability of the joint section, and the damage of the translucent insulating substrate 10 attributable to the concentration of heat or a stress on the joint section, are less likely to occur. Also, it is possible to electrically connect the positive tub line 15 and the negative tub line 16 to the terminal box 8 by a simple method.

Further, in a case where the insulating property is applied to the first layer 21 in the connection tub section 31 in each of the positive tub line 15 and the negative tub line 16 of the solar cell module 6 according to the present embodiment, it is possible to prevent the short-circuit between the connection tub section 31 and the electrode film of the thin-film photovoltaic device 1 without using the insulating film 35. Hence, it is possible for any portion of each of the positive tub line 15 and the negative tub line 16 drawn out from the reel 27 to be provided for the connection to the electrode terminals (the P-type electrode terminal 11 and the N-type electrode terminal 12) on the surface of the thin-film photovoltaic device 1.

### [Second Connection Style of Tub Line]

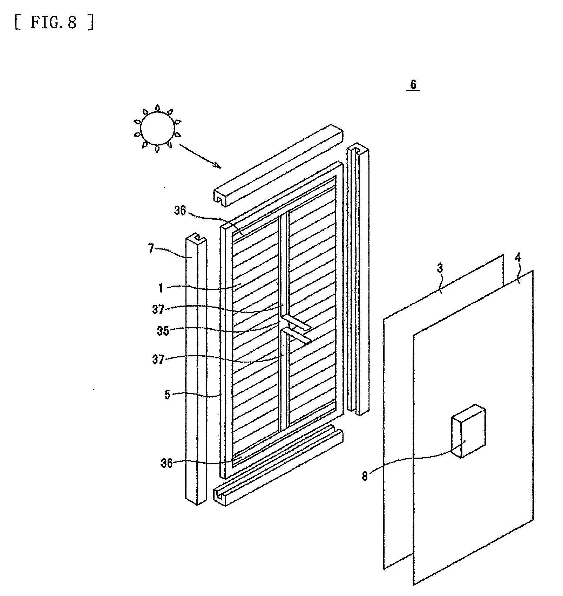

Referring to FIG. 8, the positive tub line 15 and the negative tub line 16 each may have a configuration in which a plurality of tub lines are connected. In other words, each of the positive tub line 15 and the negative tub line 16 may include a collector tub line 36 connected to the P-type electrode terminal 11 or the N-type electrode terminal 12, and a connection tub line 37 having one end connected to the collector tub line 36 and the other end connected to the connection terminal of the terminal box 8.

The collector tub line 36 is connected electrically and mechanically to the

P-type electrode terminal 11 or the N-type electrode terminal 12 via the adhesive 22 of the second layer 23 formed on the other face 20b of the conductor 20. The connection tub line 37 extends along the surface of the thin-film photovoltaic device 1 with the insulating film 35 interposed in between, and is inserted through the sealing adhesive sheet and the back sheet 4 to be connected to the connection terminal of the terminal box 8 disposed on the back sheet 4. A tip section of the connection tub line 37 is connected by soldering to the connection terminal of the terminal box 8 via the first layer 21 formed on the one face 20a of the conductor 20.

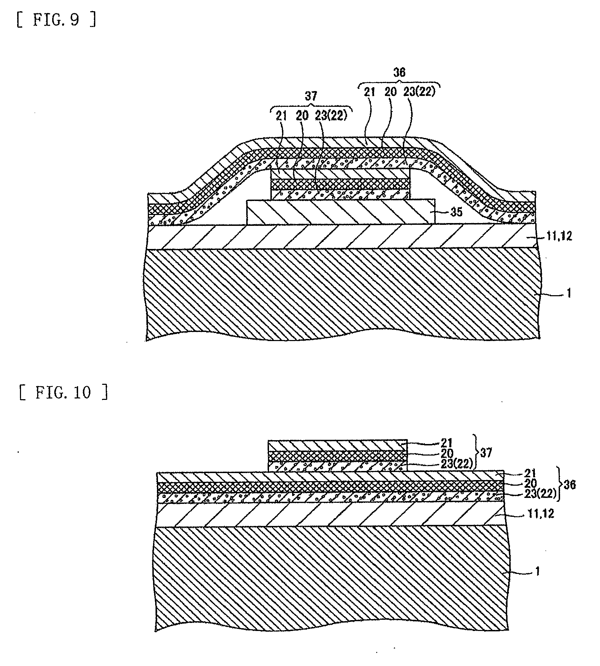

As illustrated in FIG. 9, in a case where such a positive tub line 15 and negative tub line 16 are used in the superstrate-type thin-film photovoltaic device 1, the second layer 23 of the connection tub line 37 is arranged on the surface of the thin-film photovoltaic device 1 with the insulating film 35 interposed in between, and one end thereof is arranged in the middle of each of the P-type electrode terminal 11 and the N-type electrode terminal 12 in respective longitudinal directions. The collector tub line 36 is so arranged as to be overlapped with the P-type electrode terminal 11 and the N-type electrode terminal 12 and as to stride over one end of the connection tub line 37. Thereafter, the collector tub line 36 and the connection tub line 37 are connected to the respective electrode terminals (the P-type electrode terminal 11 and the N-type electrode terminal 12) using the vacuum laminator, and a batch laminating-sealing process is performed using the sealing adhesive sheet 3 between the front side cover 5 and the back sheet 4. Thereafter, the other end of the connection tub line 37 is inserted through the sealing adhesive sheet 3 such as EVA and the back sheet 4 to be connected by soldering to the connection terminal of the terminal box 8 disposed on the back sheet 4.

Alternatively, as illustrated in FIG. 10, the positive tub line 15 and the negative tub line 16 each may have a configuration in which the connection tub line 37 is arranged on the collector tub line 36. In other words, the second layer 23 of the collector tub line 36 is arranged on the P-type electrode terminal 11 or the N-type electrode terminal 12. The second layer 23 of the connection tub line 37 is arranged on the surface of the thin-film photovoltaic device 1 with the insulating film 35 interposed in between, and one end thereof is arranged in the middle of each of the collector tub lines 36, in respective longitudinal directions, provided on the respective P-type electrode terminal 11 and N-type electrode terminal 12. Also, the collector tub line 36 and the connection tub line 37 are connected to the respective electrode terminals (the P-type electrode terminal 11 and the N-type electrode terminal 12) using the vacuum laminator, and a batch laminating-sealing process is performed using the sealing adhesive sheet 3 between the front side cover 5 and the back sheet 4. Thereafter, the other end of the connection tub line 37 is inserted through the sealing adhesive sheet 3 such as EVA and the back sheet 4 to be connected by soldering to the connection terminal of the terminal box 8 disposed on the back sheet 4.

### EXAMPLES

Next, a description is given of Examples of the invention. In the Examples, a plurality of tub lines in each of which a ratio in solid content of the flux to the anti-corrosive ink, structuring the first layer 21 formed on the one face 20a of the conductor 20, was varied were prepared to examine as to whether soldering is possible or not, as well as to examine connection resistance, appearance, and resistance to corrosion thereof.

In the tub lines according to the respective Examples and comparative examples, a solid content of the anti-corrosive ink in the first layer 21 was varied to vary the ratio in solid content of the flux to the anti-corrosive ink. Also, for each of the Examples and comparative examples, a solid content of the first layer 21 as the sum of the solid content of the flux and the solid content of the anti-corrosive ink was fixed to about 24%, and to that end a diluting solvent was used on an as-necessary basis.

In Example 1, a copper foil (GTS-MP available from Furukawa Electric Co., Ltd.) having a thickness of 35 µm was used as the conductor 20, and the one face 20a thereof was coated with the liquid in which the flux and the anti-corrosive ink was mixed using the wire bar, following which drying was performed at a temperature of 80 degrees centigrade for 5 minutes to form the first layer 21. Also, the other face 20b of the conductor 20 was coated with the conductive adhesion paste to form the second layer 23.

The first layer 21 had a thickness in a range from 3 µm to 5 µm (4 µm thickness plus or minus one µm). As the flux, 3.00 grams of ES-0307LS available from Senju Metal Industry Co., Ltd. was mixed in which a solid content of flux was 0.60 grams. As the anti-corrosive ink, 4.19 grams of black ink containing pigment-based carbon black (available from Dainichiseika Color & Chemicals Mfg. Co., Ltd.), 0.21 grams of cross-linker (SS Hardener available from Dainichiseika Color & Chemicals Mfg. Co., Ltd.), and 2.60 grams of diluting solvent (ALMIC No. 18 available from Dainichiseika Color & Chemicals Mfg. Co., Ltd.) were mixed. A solid content of the anti-corrosive ink was 1.80 grams.

A solid content of the first layer 21 as the sum of the solid content of the flux and the solid content of the anti-corrosive ink was 24%, and a mixing ratio in solid content of the flux to the anti-corrosive ink was defined as: (flux) : (anti-corrosive ink) = 1:3.

In Example 2, factors including the flux component and the thickness of the first layer 21 were the same in condition as the Example 1. As the anti-corrosive ink, 2.79 grams of black ink containing pigment-based carbon black (available from Dainichiseika Color & Chemicals Mfg. Co., Ltd.), 0.14 grams of cross-linker (SS Hardener available from Dainichiseika Color & Chemicals Mfg. Co., Ltd.), and 1.57 grams of diluting solvent (ALMIC No. 18 available from Dainichiseika Color & Chemicals Mfg. Co., Ltd.) were mixed. A solid content of the anti-corrosive ink was 1.20 grams.

A solid content of the first layer 21 as the sum of the solid content of the flux and the solid content of the anti-corrosive ink was 24%, and a mixing ratio in solid content of the flux to the anti-corrosive ink was defined as: (flux) : (anti-corrosive ink) = 1:2.

In Example 3, factors including the flux component and the thickness of the first layer 21 were the same in condition as the Example 1. As the anti-corrosive ink, 1.40 grams of black ink containing pigment-based carbon black (available from Dainichiseika Color & Chemicals Mfg. Co., Ltd.), 0.07 grams of cross-linker (SS Hardener available from Dainichiseika Color & Chemicals Mfg. Co., Ltd.), and 0.53 grams of diluting solvent (ALMIC No. 18 available from Dainichiseika Color & Chemicals Mfg. Co., Ltd.) were mixed. A solid content of the anti-corrosive ink was 0.60 grams.

A solid content of the first layer 21 as the sum of the solid content of the flux and the solid content of the anti-corrosive ink was 24%, and a mixing ratio in solid content of the flux to the anti-corrosive ink was defined as: (flux) : (anti-corrosive ink) = 1:1.

In Example 4, factors including the flux component and the thickness of the first layer 21 were the same in condition as the Example 1. As the anti-corrosive ink, 0.70 grams of black ink containing pigment-based carbon black (available from Dainichiseika Color & Chemicals Mfg. Co., Ltd.) and 0.03 grams of cross-linker (SS Hardener available from Dainichiseika Color & Chemicals Mfg. Co., Ltd.) were mixed. No diluting solvent was mixed. A solid content of the anti-corrosive ink was 0.30 grams.

A solid content of the first layer 21 as the sum of the solid content of the flux and the solid content of the anti-corrosive ink was 24%, and a mixing ratio in solid content of the flux to the anti-corrosive ink was defined as: (flux) : (anti-corrosive ink) = 2:1.

In Example 5, factors including the flux component and the thickness of the first layer 21 were the same in condition as the Example 1. As the anti-corrosive ink, 0.47 grams of black ink containing pigment-based carbon black (available from Dainichiseika Color & Chemicals Mfg. Co., Ltd.) and 0.02 grams of cross-linker (SS Hardener available from Dainichiseika Color & Chemicals Mfg. Co., Ltd.) were mixed. No diluting solvent was mixed. A solid content of the anti-corrosive ink was 0.20 grams.

A solid content of the first layer 21 as the sum of the solid content of the flux and the solid content of the anti-corrosive ink was 23%, and a mixing ratio in solid content of the flux to the anti-corrosive ink was defined as: (flux) : (anti-corrosive ink) = 3:1.

Example 6 was the same in condition as the Example 3 with the exception that the thickness of the first layer 21 was in a range from 1 µm to 3 µm.

Example 7 was the same in condition as the Example 3 with the exception that the thickness of the first layer 21 was in a range from 5 µm to 8 µm.

Example 8 was the same in condition as the Example 3 with the exception that the insulating adhesion film was used as the adhesive 22 of the second layer 23.

In comparative example 1, coating of a liquid mixed with a flux component but containing no anti-corrosive component was performed to form the first layer 21. As the flux, 10 grams of ES-0307LS available from Senju Metal Industry Co., Ltd. was mixed in which a solid content of flux was 2.0 grams. Further, heating was performed to volatilize a solvent contained therein, whereby a solid content of the flux, i.e., a solid content of the first layer 21, was adjusted to 24%. A mixing ratio in solid content of the flux to the anti-corrosive ink was defined as: (flux) : (anti-corrosive ink) = 1:0.

In comparative example 2, coating of a liquid mixed with an anti-corrosive component but containing no flux component was performed to form the first layer 21. As the anti-corrosive ink, 3.0 grams of black ink containing pigment-based carbon black (available from Dainichiseika Color & Chemicals Mfg. Co., Ltd.), 0.15 grams of cross-linker (SS Hardener available from Dainichiseika Color & Chemicals Mfg. Co., Ltd.), and 2.01 grams of diluting solvent (ALMIC No. 18 available from Dainichiseika Color & Chemicals Mfg. Co., Ltd.) were mixed. A solid content of the anti-corrosive ink was 1.24 grams. A solid content of the anti-corrosive ink, i.e., a solid content of the first layer 21, was 24%, and a mixing ratio in solid content of the flux to the anti-corrosive ink was defined as: (flux) : (anti-corrosive ink) = 0:1.

In comparative example 3, a tub line was prepared in which no first layer 21 was formed on the one face of the conductor 20.

For the tub line according to each of the foregoing Examples and comparative examples, examination was conducted as to whether soldering is possible or not, and as to connection resistance, appearance, and resistance to corrosion thereof. To examine whether the soldering is possible or not, a soldering iron at a temperature of 400 degrees centigrade was used to determine a case in which soldering connection of the first layer 21 to the connection terminal of the terminal box was possible within less than 10 seconds, which was defined as ○, a case in which the soldering connection thereof was possible within not less than 10 seconds and less than 15 seconds, which was defined as Δ, and a case in which the soldering connection thereof was not possible within less than 15 seconds, which was defined as x.

As for the connection resistance, determination was made as a case in which a connection resistance value was equivalent to a connection resistance value of a regular soldering connection of a copper foil in 2A conduction, which was defined as ○, a case in which a rise in the connection resistance value from the connection resistance value of the regular soldering connection of the copper foil was less than 10 mΩ, which was defined as Δ, and a case in which a rise in the connection resistance value from the connection resistance value of the regular soldering connection of the copper foil was not less than 10 mΩ, which was defined as ×.

As for the appearance test, determination was made as to a case in which an underlying copper color was not confirmable upon visual observation of the tub line following the formation of the first layer 21, which was defined as ○, a case in which the underlying copper color was slightly confirmable, which was defined as Δ, and a case in which the underlying copper color was clearly confirmable, which was defined as ×.

As for the resistance to corrosion, determination was made as to a case in which discoloration of the first layer 21 was not confirmed upon visual observation of the first layer 21 following a pressure cooker test (PCT: 85 °C, 85%, 1000 hr) after sealing the tub line according to each of the foregoing Examples and comparative examples using an EVA sheet, which was defined as ○, a case in which significant discoloration was not confirmed, which was defined as Δ, and a case in which the significant discoloration was confirmed, which was defined as x.

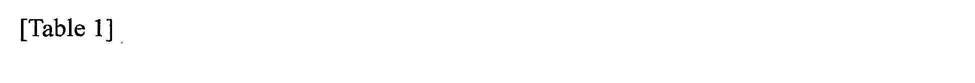

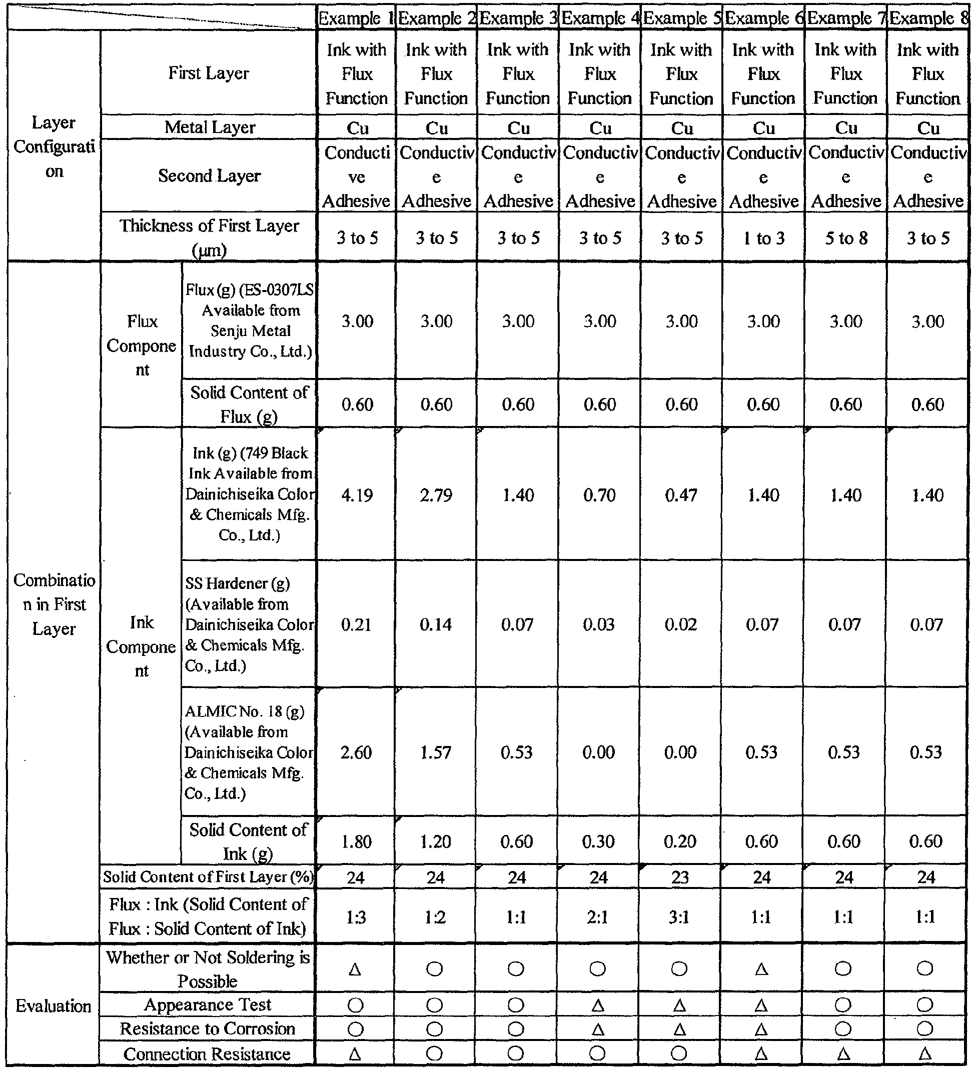

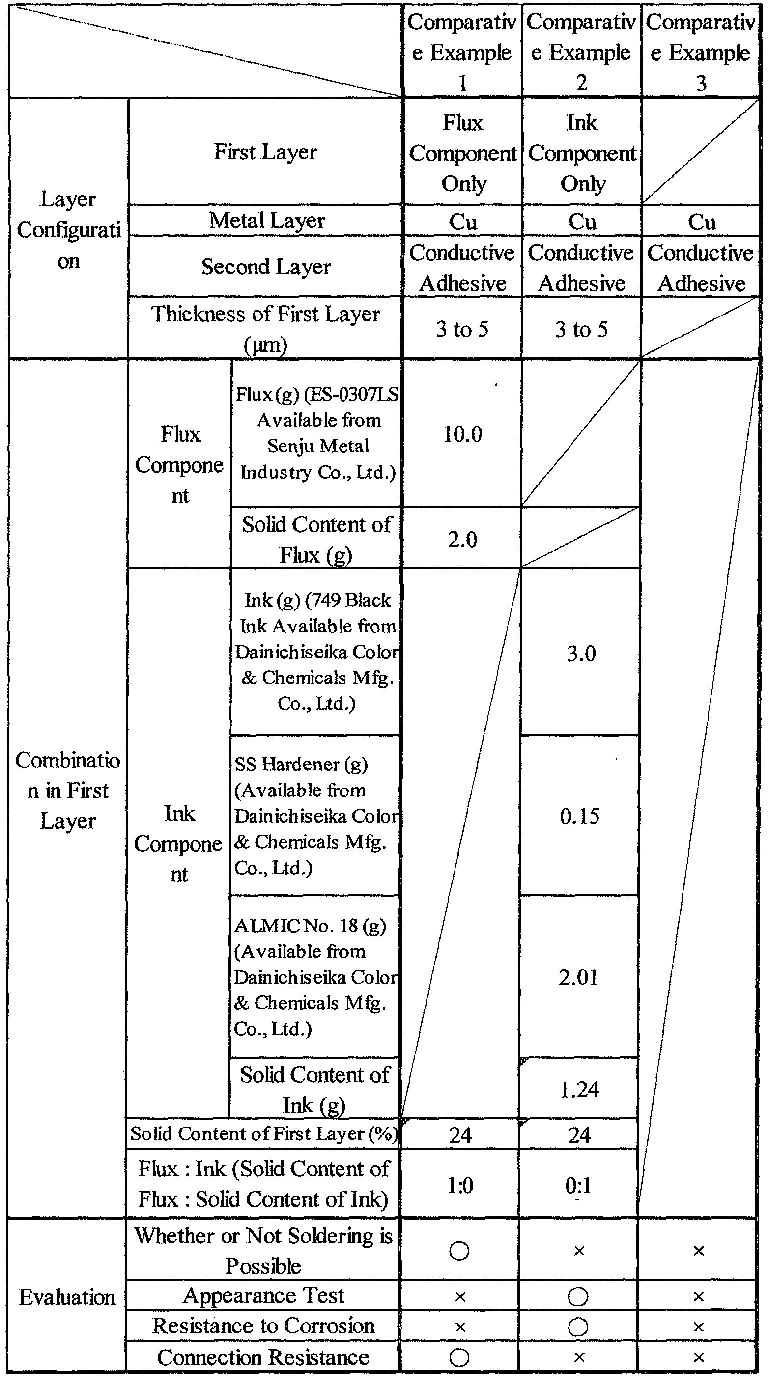

As shown in Table 1, the coating of the liquid having the flux and the anti-corrosive ink was performed to form the first layer 21 in each of the Examples 1 to 8; hence, wettability of a solder was improved and the soldering connection was performable promptly and with certainty, which led to favorable results for the factors regarding whether or not the soldering is possible and the connection resistance value. Also, the anti-corrosive ink was contained in the first layer 21 in each of the Examples 1 to 8; hence, favorable results were achieved for the resistance to corrosion even under a situation of being sealed by the EVA and being placed under acetic acid gas atmosphere resulting from an increase in temperature. Further, the black ink containing pigment-based carbon black was used for the anti-corrosive ink; hence, the underlying copper color was prevented from being appeared. This makes it possible to maintain favorable appearance especially when attachment thereof is performed on the substrate-type thin-film photovoltaic device.

On the other hand, favorable results were achieved for the factors regarding whether or not the soldering is possible and the connection resistance value in the comparative example 1 by virtue of the flux component contained therein. However, the anti-corrosive ink was not contained therein, which resulted in clear emergence of the underlying copper color and the discoloration of the tub line attributed to corrosion following the PCT test in the appearance test.

Conversely, the factors regarding the appearance test and the resistance to corrosion were favorable in the comparative example 2 by virtue of the anti-corrosive ink contained therein. However, the flux component was not contained therein, which resulted in failure to perform sufficient solder connection within less than 15 seconds using the soldering iron at the temperature of 400 degrees centigrade in the soldering and a consequent rise in the connection resistance value.

In the comparative example 3, no coating of the liquid having the flux component and the anti-corrosive ink component was performed, which resulted in failure to achieve favorable results for the respective items regarding whether the soldering is possible or not, as well as the connection resistance, the appearance, and the resistance to corrosion.

Also, it can be seen from the results in the Examples 2 and 3 that the definition of (flux) : (anti-corrosive ink) = 1:1 to 1:2 both inclusive is particularly preferable for the mixing ratio in solid content of the flux to the anti-corrosive ink.

In addition, when comparing the Example 6 with any other Example, it can be seen that, for the layer thickness of the first layer 21, a range from 1 µm to 10 µm both inclusive is preferable, a range from 1 µm to 8 µm both inclusive is more preferable, and a range from 3 µm to 5 µm both inclusive is particularly preferable.

The present application claims the priority benefit of Japanese Patent Application No. 2012-158781 filed in the Japan Patent Office on July 17, 2012, the entire content of which is hereby incorporated by reference.

It should be understood by those skilled in the art that various modifications, combinations, sub-combinations and alterations may occur depending on design requirements and other factors insofar as they are within the scope of the appended claims or the equivalents thereof.

## Claims

1. A wiring member, comprising:
a conductor having a first face and a second face that is located opposite to the first face;
a first layer provided on the first face of the conductor, and containing a flux component and an anti-corrosive component; and
a second layer provided on the second face of the conductor, and including an adhesive.

2. The wiring member according to claim 1, wherein the wiring member is configured to be connected to a surface electrode of a photovoltaic device via the second layer, and is configured to be connected to a terminal box via the first layer, the terminal box allowing electric power generated by the photovoltaic device to be taken out to outside.

3. The wiring member according to claim 1, wherein a mixing ratio in solid content of the flux component to the anti-corrosive component is defined as:
the flux component: the anti-corrosive component = 1:3 to 3:1 both inclusive.

4. The wiring member according to claim 1, wherein the first layer has a thickness in a range from 1 µm to 8 µm both inclusive.

5. The wiring member according to claim 1, wherein the wiring member has a tape-like shape, and is wound around a reel to configure a wound body.

6. A solar cell module, comprising:
a photovoltaic device having a surface electrode;
a terminal box allowing electric power generated by the photovoltaic device to be taken out to outside; and
a wiring member electrically connecting the surface electrode of the photovoltaic device to the terminal box, the wiring member including:
a conductor having a first face and a second face that is located opposite to the first face;
a first layer provided on the first face of the conductor, and containing a flux component and an anti-corrosive component; and
a second layer provided on the second face of the conductor, and including an adhesive.

7. The solar cell module according to claim 6, wherein the wiring member is connected to the surface electrode of the photovoltaic device via the second layer, and is connected to the terminal box via the first layer.

8. The solar cell module according to claim 7, wherein
the photovoltaic device is a thin-film photovoltaic device, and
the first layer has an insulating property, and is disposed on a surface of the photovoltaic device.

9. The solar cell module according to claim 8, wherein the wiring member has a seamless tape-like shape.

10. A method of manufacturing a solar cell module, the method comprising:
forming a wiring member through providing a first layer on a first face of a conductor and a second layer on a second face of the conductor, the second face being located opposite to the first face, the first layer containing a flux component and an anti-corrosive component, and the second layer including an adhesive; and
connecting the wiring member to a surface of a photovoltaic device via the second layer, and connecting the wiring member to a terminal box via the first layer, the terminal box allowing electric power generated by the photovoltaic device to be taken out to outside.

11. The method of manufacturing the solar cell module according to claim 10, wherein a mixing ratio in solid content of the flux component to the anti-corrosive component is defined as:
the flux component : the anti-corrosive component = 1:3 to 3:1 both inclusive.

12. The method of manufacturing the solar cell module according to claim 10, wherein the first layer has a thickness in a range from 1 µm to 8 µm both inclusive.

13. The method of manufacturing the solar cell module according to claim 10, further comprising:
forming the wiring member in a tape-like shape;
winding the wiring member around a reel to configure a wound body;
drawing out a seamless wiring member from the wound body; and
connecting the surface of the photovoltaic device to the terminal box using the seamless wiring member.

14. The method of manufacturing the solar cell module according to claim 13, wherein one end of the wiring member is connected via the second layer to a surface electrode formed on the photovoltaic device, and another end of the wiring member is connected via the first layer to the terminal box.
